# EUROPEAN PATENT SPECIFICATION

(11) **EP 2 248 195 B1**
(45) Date of publication and mention of the grant of the patent: **31.07.2013**
(21) Application number: 08873181.5
(22) Date of filing: 29.02.2008
(51) Int. Cl.: H01L 35/16, H01L 35/34

(54) **THERMOELECTRIC NANOCOMPOSITE, METHOD FOR MAKING THE NANOCOMPOSITE AND APPLICATION OF THE NANOCOMPOSITE**
THERMOELEKTRISCHES NANOKOMPOSIT, VERFAHREN ZUR HERSTELLUNG DES NANOKOMPOSITS UND ANWENDUNG DES NANOKOMPOSITS
NANOCOMPOSITE THERMOELECTRIQUE, PROCEDE DE FABRICATION DU NANOCOMPOSITE ET APPLICATION DU NANOCOMPOSITE

(43) Date of publication of application: 10.11.2010
(73) Proprietor: Siemens Aktiengesellschaft, 80333 München (DE)
(72) Inventor: BLANK, Vladimir Davidovich, Moscow Reg. Troitsk 142190 (RU); PIVOVAROV, Gennadii Ivanovich, Moscow Reg. Troitsk 142190 (RU); POPOV, Mikhail Yurievich, Moscow Reg. Troitsk 142190 (RU); TATYANIN, Evgeny Vasilievich, Moscow Reg. Troitsk 142190 (RU)
(86) International application number: PCT/RU2008/000120
(87) International publication number: WO 2009/110815

(56) References cited:
- EP-A- 1 187 230
- WO-A-2006/137923
- WO-A-2008/048302
- US-A1- 2004 187 905
- US-A1- 2006 118 158
- ZHAN ET AL: "Thermoelectric properties of carbon nanotube/ceramic nanocomposites" SCRIPTA MATERIALIA, ELSEVIER, AMSTERDAM, NL, vol. 54, no. 1, 1 January 2006 (2006-01-01), pages 77-82, XP005126200 ISSN: 1359-6462
- NI H L ET AL: "Synthesis and thermoelectric properties of Bi2Te3 based nanocomposites" JOURNAL OF ALLOYS AND COMPOUNDS, ELSEVIER SEQUOIA, LAUSANNE, CH, vol. 397, no. 1-2, 19 July 2005 (2005-07-19), pages 317-321, XP004925814 ISSN: 0925-8388
- TOKORO H ET AL: "Iron nanoparticles coated with graphite nanolayers and carbon nanotubes" DIAMOND AND RELATED MATERIALS, ELSEVIER SCIENCE PUBLISHERS, AMSTERDAM, NL, vol. 13, no. 4-8, 1 April 2004 (2004-04-01), pages 1270-1273, XP004507958 ISSN: 0925-9635

## Description

### BACKGROUND OF THE INVENTION

### 1. Field of the Invention

This invention relates to a thermoelectric nanocomposite, a method for making the thermoelectric nanocomposite and an application of the nanocomposite.

### 2. Description of the Related Art

The best traditional thermoelectric (TE) materials used for heat-to-power conversion systems have a thermoelectric figure of merit ZT = S²σT/k of about 1 (S is the Seebeck coefficient, σ is the electrical conductivity, k is the thermal conductivity, T is the average temperature of a thermoelectric device with the thermoelectric materials). This limits practical applications, where ZT > 2.5 is required.

For nanostructured materials ZT in the range of 2.5 to 4 was demonstrated. Main target and effect of nanostructuring is a manipulation of ZT by creating conditions for phonon-blocking/electron-transmitting effects. The nanostructured materials were synthesized using homoepitaxial growth procedure. This procedure does not provide opportunities for industrial production of nanostructured thermoelectric materials.

In WO 2006/137923 A2 a thermoelectric nanocomposite which exhibit enhanced thermoelectric properties is proposed. The nanocomposite includes two or more components. The components are semiconductors like silicon and germanium. At least one of the components comprises nanostructed material, e.g. silicon nanoparticles.

In US 2004/0187905 A1 a thermoelectric nanocomposite comprising a plurality of ceramic nanoparticles (average particle size < 100 nm) and a method for making the nanocomposite are provided. The material of the nanoparticles is for example a compound like Be₂Te₃ and Sb₂Te₃. The method for making the nanocomposite comprises following steps: Providing a bulk material of the ceramic material, milling the bulk material to a ceramic powder with the ceramic nanoparticles and heat treatment of the ceramic powder. Before starting the milling process additional material like fullerenes may be added. The addition of fullerenes leads to a mechanical alloying of the ceramic powder and the fullerens during the milling process. The resulting nanocomposite comprises inhomogeneous core shell ceramic nanoparticles. Moreover the fullerenes are destroyed during the mechanical alloying. Both lead to an undefined, hardly reproducible thermoelectric nanocomposite with hardly predictable features.

From the US 2006/1181158 A1 a thermolelectric nanocomposite is known, which comprises a plurality of homogenous ceramic nanoparticles with bismuth telluride as tellurium compound, however this material does not include ceramic particles which are coated with a particle coating that comprises at least one layer with carbon material.

Zhan et al. in "Thermoelectric properties of carbon nanotube/ceramic nanocomposites" SCRIPTA MATERIALIA, ELSEVIER, AMSTERDAM, NL, vol.54, no.1, pages 77 - 82 as well as Tokoro et al in "Iron nanoparticles coated with graphite nanolayers and carbon nanotubes" Diamond and related materials, Elsevier Science Publishers, Amsterdam, NL, vol. 13, no. 4-8, 1 April 2004, pages 1270 - 1273 show insulating ceramic or metallic nanoparticles coated with carbon nanotubes.

### SUMMARY OF THE INVENTION

It is an object of the invention to provide a thermoelectric nanocomposite with well predictable features. Another object of the invention is the providing of a method for making the thermoelectric nanocomposite. The method should be easy and reproducible.

These objects are achieved by the inventions specified in the claims.

The idea behind the invention is a modification of the known thermoelectric nanocomposite and a modification of the method for making the thermoelectric nanocomposite.

The present invention provides a thermoelectric nanocomposite comprising:
- a plurality of homogenous ceramic nanoparticles with at least one kind of tellurium compound;
- the ceramic nanoparticles comprise an average particle size selected from a range of about 5 nm to about 30 nm;
- the ceramic nanoparticles are part of a nanocomposite characterized in that
- the ceramic nanoparticles are coated with a particle coating in each case;
- the particle coating comprises at least one layer with nanostructured, substantially intact carbon material.

Additionally, the present invention is directed to a method for making a thermoelectric nanocomposite,
the nanocomposite comprising:
- a plurality of homogenous ceramic nanoparticles with at least one kind of tellurium compound;
- the homogenous ceramic nanoparticles comprise an average particle size selected from a range of about 5 nm to about 30 nm;
- the ceramic nanoparticles are part of a nanocomposite characterized in that
- the homogenous ceramic nanoparticles are coated with a particle coating in each case;
- the particle coating comprises at least one layer with nanostructured, substantially intact carbon material,
   the method comprising:
- providing a precursor powder of a plurality of homogenous ceramic nanoparticles with at least one kind of a tellurium compound having an average particle size selected from a range of about 5 nm to about 30 nm, wherein the homogenous ceramic nanoparticles comprise a precursor coating with nanostructured, substantially intact carbon material in each case, and
- heat treatment of the precursor powder such, that the nanocomposite is generated by conversion of the precursor coating to the particle coating.

According to a preferred embodiment the average particle size is below 20 nm. A homogenous ceramic nanoparticle is throughout uniform concerning its physical and chemical features. E.g. such a nanoparticle doesn't have any core shell structure. An alloying doesn't occur. In contrast to the state of the art, carbon is not built in into the ceramic tellurium compound. Moreover the coating with the nanostructured carbon material is intact. This means that the carbon material is not harmed or destructed, respectively. A harming or a destruction of the nanostructured carbon material would occur in the case of mechanical alloying.

As nanostructured carbon material any suitable material or a mixture of these materials are possible. In a particular embodiment the nanostructured carbon material is selected from the group consisting of fullerenes and carbon nanotubes. The carbon nanotubes can be single wall carbon nanotubes (SWCNts) or multi wall carbon nanotubes (MWNTs).

In particular fullerenes are suitable as nanostructured carbon material. In a preferred embodiment the fullerenes are selected from the group consisting of C₃₆, C₆₀, C₇₀ and C₈₁. Just one kind of fullerenes can be used. A mixture of two or more kinds of these fullerenes is possible, too.

The nanostructured carbon material can be used unmodified. A base material of the nanostructured carbon material is used. In a further embodiment the nanostructured carbon material is chemically modified. This means that one or more derivatives of the nanostructured carbon material are used. For example the used fullerenes are functionalized. Functional groups are connected to the base material of the fullerenes. Moreover the use of dimers or trimers of the fullerenes is possible, too.

The particle coating comprises at least one layer with the nanostructured carbon material. In a further embodiment the layer is continuous or interrupted. E.g. an interrupted layer is achieved by regions of fullerenes which are separated from each other, so that they build isles.

In principle the number of layers with the nanostructures carbon material is arbitrary. But especially with low numbers of these layers well thermoelectric properties result. Therefore in a preferred embodiment the particle coating comprises five layers with the nanostructured carbon material in maximum and particularly three layers with the nanostructured carbon material in maximum. In particular a monolayer with the nanostructured carbon material is suitable.

Different tellurium compounds are possible. In a particular embodiment the tellurium compound comprises at least one element selected from the group consisting of antimony (Sb) and bismuth (Bi). Further elements like lead (Pb) or selenium (Se) are possible, too. According to a preferred embodiment the tellurium compound is at least one telluride selected from the group consisting of Bi₂Te₃ and Sb₂Te₃. A Mixture of these compounds is possible as well as a solid solution of these compounds.

Concerning the method for making the thermoelectric nanocomposite it is preferable, that the providing of the precursor powder includes providing a powder mixture of a ceramic powder and a carbon powder, wherein the ceramic powder comprises the plurality of homogeneous ceramic nanoparticles with at least one kind of a tellurium compound having an average particle size selected from a range of about 5 nm to about 30 nm and particularly to about 10 nm, and wherein the carbon powder comprises the nanostructured, substantially intact carbon material.

According to a particular embodiment the providing the powder mixture includes milling a ceramic raw material of the ceramic powder resulting in the ceramic powder, adding the carbon powder to the ceramic powder and mixing the ceramic powder and the carbon powder such, that the powder mixture is generated. The carbon powder is added shortly before finishing the milling process or after the milling process. The milling includes ball milling or something like that.

The precursor powder can be directly subjected to the heat treatment. Better results can be achieved by making the precursor powder before the heat treatment more compact. Therefore, according to a particular embodiment the providing the precursor powder includes a mechanical compacting of the precursor powder. Mechanical pressure is exerted on the precursor powder.

The resulted precursor powder is formed during the pressure process. After the pressure process heat treatment is carried out at up to 400°C and particularly at up to 350°C.

The resulting thermoelectric nanocomposite shows excellent thermoelectric properties. The thermoelectric nanocomposite is preferably used in a component for a heat-to-power system, e.g. a Peltier element.

Beyond the advantages mentioned before following additional advantages are to be pointed out: The samples are reproducible and mechanically stable. The synthesis procedure permits optimization of the samples properties by variation of the concentration of the nanostructured carbon material. The thermoelectric nanocomposite can be synthesized in amount which is enough for devises production.

### BRIEF DESCRIPTION OF THE DRAWINGS

Further features and advantages of the invention are produced from the description of exemplary embodiments with reference to the drawing.
Figure 1 shows a transmission electron microscope image of nanoparticles (nano-cristallites) of Bi₂Te₃ covered by a monolayer of C₆₀ molecules.
Figure 2 shows raman spectra of the relevant materials.

### DETAILED DESCRIPTION OF THE INVENTION

The thermoelectric nanocomposite comprises: a plurality of homogeneous ceramic nanoparticles. The tellurium compounds are in a first example a p-type of Bi₂Te₃ (Bi₂Te₃ and 26 atomic% of Sb₂Te₃) and in a second example only Bi₂Te₃. The average particle size of the nanoparticles is about 20 nm. The ceramic nanoparticles are coated with a particle coating in each case. The particle coating comprises one layer with nanostructured, substantially intact carbon material in each case. The nanostructured carbon material is unmodified fullerene C₆₀.

The method for making the thermoelectric nanocomposites comprises following steps: providing a precursor powder of a plurality of homogeneous ceramic nanoparticles, wherein the homogeneous ceramic nanoparticles comprise a precursor coating with C₆₀ molecules, and heat treatment of the precursor powder such, that the nanocomposite is generated by conversion of the precursor coating into to the particle coating.

Initial materials are following are p-type of Bi₂Te₃ (Bi₂Te₃ and 26 atomic% of Sb₂Te₃) with an impurity of less than 10⁻⁴, Bi₂Te₃ with an impurity less than 10⁻⁴ and fullerene C₆₀ with a purity of about 99.99%.

For the providing the precursor powder a milling of bulk material of the tellurium compounds into a ceramic powder and mixing with carbon powder with C₆₀ molecules is executed. For this planetary mill is rotated with acceleration of 17-19 g (acceleration of gravity). Stainless steel balls with a diameter of about 7 mm are used. A ratio of the balls to the treated material is about 8 g. Loading of the treated material was performed on glove box in argon (Ar) atmosphere. The following procedure of the treatment was selected: 1h milling of Bi₂Te₃, adding of C₆₀ powder and 0.5 h treatment of Bi₂Te₃ with C₆₀. The compacting of the powder after the milling process was performed in a piston-cylinder cell under pressure 2 GPa. The pressurized tablets were agglomerated at 350°C during 2 h in Ar atmosphere. Diameter of the samples is 10 mm and thickness 1 mm.

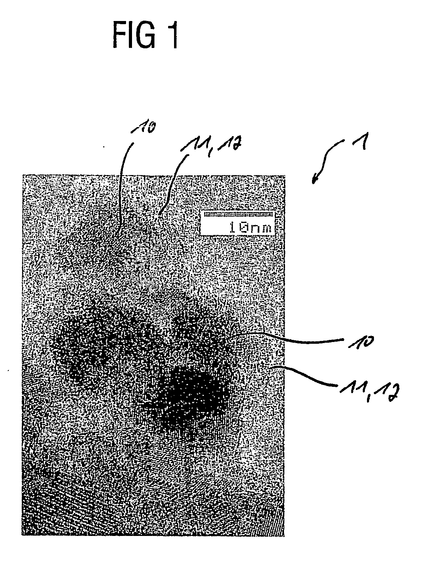

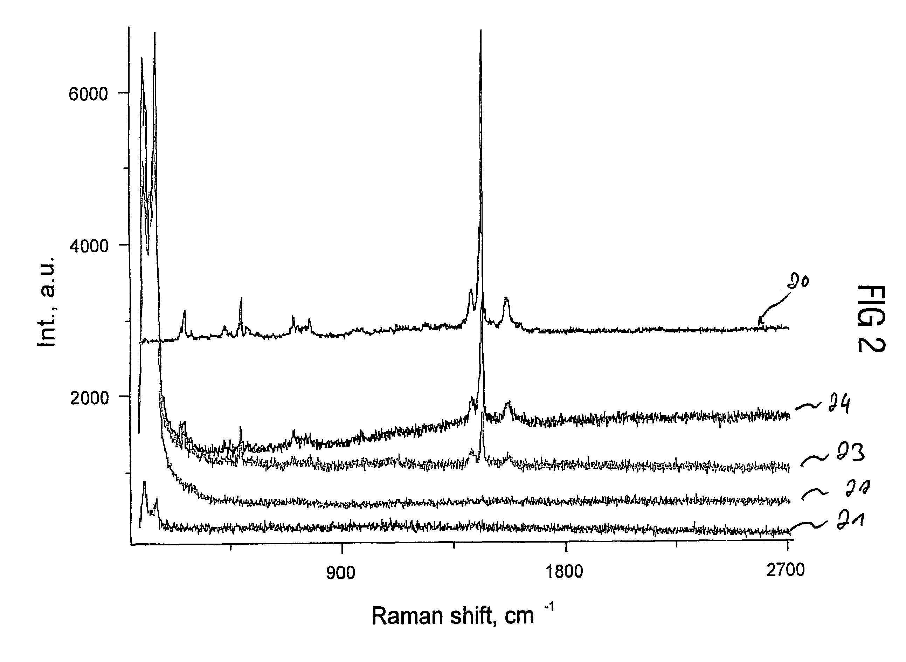

The following procedures were used for characterization of the samples: X-ray, Raman (Figure 2), Transmission Electron Microscopy (TEM), Atomic Force Microscopy (AFM), hardness tests. Figure 1 presents the nanocomposite 1 with the key elements: Nano-crystallites (nanoparticles) 10 of Bi₂Te₃ covered by a coating 11 with the monolayer 12 of C₆₀ molecules. The monolayer has a thickness below 1 nm. In figure 2 the raman spectra of the C₆₀ initial material (20), of initial p-type Bi₂Te₃ (21), milled p-type Bi₂Te₃ (22), mixture of the p-type Bi₂Te₃ - powder and the C60 powder (precursor powder, 23) and the heat treated precursor powder leading to the thermoelectric nanocomposite (24).

## Claims

1. Thermoelectric nanocomposite (1) comprising:
- a plurality of homogenous ceramic nanoparticles (11) with at least one kind of tellurium compound;
- the ceramic nanoparticles comprise an average particle size selected from a range of about 5 nm to about 30 nm;
- the ceramic nanoparticles are part of a nanocomposite **characterized in that**
- the ceramic nanoparticles are coated with a particle coating (11) in each case;
- the particle coating comprises at least one layer (12) with nanostructured, substantially intact carbon material.

2. Thermoelectric nanocomposite (1) according to claim 1, wherein the nanostructured carbon material is selected from the group consisting of fullerenes and carbon nanotubes.

3. Thermoelectric nanocomposite (1) according to claim 2, wherein the fullerenes are selected from the group consisting of C36, C60 and C80.

4. Thermoelectric nanocomposite (1) according to one of the previous claims, wherein the nanostructured carbon material is chemically modified.

5. Thermoelectric nanocomposite (1) according to one of the previous claims, wherein the layer (12) is continuous or interrupted.

6. Thermoelectric nanocomposite (1) according to one of the previous claims, wherein the particle coating (11) comprises five layers with the nanostructured carbon material in maximum and particularly three layers with the nanostructured carbon material in maximum.

7. Thermoelectric nanocomposite (1) according to one of the previous claims, wherein the tellurium compound comprises at least one element selected from the group consisting of antimony and bismuth.

8. Nanocomposite (1) according to one of the previous claims, wherein the tellurium compound is at least one telluride selected from the group consisting of Bi₂Te₃ and Sb₂Te₃.

9. Method for making a thermoelectric nanocomposite (1), the nanocomposite comprising:
- a plurality of homogenous ceramic nanoparticles with at least one kind of tellurium compound;
- the homogenous ceramic nanoparticles comprise an average particle size selected from a range of about 5 nm to about 30 nm;
- the ceramic nanoparticles are part of a nanocomposite **characterized in that**
- the homogenous ceramic nanoparticles are coated with a particle coating (11) in each case;
- the particle coating comprises at least one layer (12) with nanostructured, substantially intact carbon material,
the method comprising:
- providing a precursor powder of a plurality of homogenous ceramic nanoparticles with at least one kind of a tellurium compound having an average particle size selected from a range of about 5 nm to about 30 nm, wherein the homogenous ceramic nanoparticles comprise a precursor coating with nanostructured, substantially intact carbon material in each case, and
- heat treatment of the precursor powder such, that the nanocomposite is generated by conversion of the precursor coating into the particle coating (11).

10. Method according to claim 9, wherein the providing of the precursor powder includes providing a powder mixture of a ceramic powder and a carbon powder, wherein the ceramic powder comprises the plurality of homogenous ceramic nanoparticles with at least one kind of a tellurium compound having an average particle size selected from a range of about 5 nm to about 30 nm, the ceramic nanoparticles are part of a nanocomposite (1)
**characterized in that**
the carbon powder comprises the nanostructured, substantially intact carbon material.

11. Method according to claim 10, wherein the providing the powder mixture includes
- milling a ceramic raw material of the ceramic powder resulting in the ceramic powder,
- adding the carbon powder to the ceramic powder and
- mixing the ceramic powder and the carbon powder such, that the powder mixture is generated.

12. Method according to one of the previous claims, wherein the providing the precursor powder includes a mechanical compacting the precursor powder.

13. Method according to one of the previous claims, wherein the heat treatment is carried out at up to 400°C and particularly at up to 350°C.

14. Application of the thermoelectric nanocomposite (1) according to claim 1 to claim 8 as a thermoelectric component for a heat-to-power system.

## Patentansprüche

1. Thermoelektrisches Nanokomposit (1), welches umfasst:
- eine Vielzahl von homogenen keramischen Nanopartikeln (11) mit mindestens einer Art von Tellurverbindung;
- wobei die keramischen Nanopartikel eine mittlere Teilchengröße aufweisen, die aus einem Bereich von etwa 5 nm bis etwa 30 nm ausgewählt ist;
- wobei die keramischen Nanopartikel Teil eines Nanokomposits sind,
**dadurch gekennzeichnet, dass**
- die keramischen Nanopartikel jeweils mit einer Partikelbeschichtung (11) beschichtet sind;
- die Partikelbeschichtung mindestens eine Schicht (12) mit nanostrukturiertem, im Wesentlichen intaktem Kohlenstoffmaterial umfasst.

2. Thermoelektrisches Nanokomposit (1) nach Anspruch 1, wobei das nanostrukturierte Kohlenstoffmaterial aus der Gruppe ausgewählt ist, die aus Fullerenen und Kohlenstoff-Nanoröhren besteht.

3. Thermoelektrisches Nanokomposit (1) nach Anspruch 2, wobei die Fullerene aus der Gruppe ausgewählt sind, die aus C36, C60 und C80 besteht.

4. Thermoelektrisches Nanokomposit (1) nach einem der vorhergehenden Ansprüche, wobei das nanostrukturierte Kohlenstoffmaterial chemisch modifiziert ist.

5. Thermoelektrisches Nanokomposit (1) nach einem der vorhergehenden Ansprüche, wobei die Schicht (12) zusammenhängend oder unterbrochen ist.

6. Thermoelektrisches Nanokomposit (1) nach einem der vorhergehenden Ansprüche, wobei die Partikelbeschichtung (11) maximal fünf Schichten mit dem nanostrukturierten Kohlenstoffmaterial und insbesondere drei Schichten mit dem nanostrukturierten Kohlenstoffmaterial umfasst.

7. Thermoelektrisches Nanokomposit (1) nach einem der vorhergehenden Ansprüche, wobei die Tellurverbindung mindestens ein Element umfasst, das aus der Gruppe ausgewählt ist, die aus Antimon und Bismut besteht.

8. Nanokomposit (1) nach einem der vorhergehenden Ansprüche, wobei die Tellurverbindung mindestens ein Tellurid ist, das aus der Gruppe ausgewählt ist, die aus Bi₂Te₃ und Sb₂Te₃ besteht.

9. Verfahren zur Herstellung eines thermoelektrischen Nanokomposits (1), wobei das Nanokomposit umfasst:
- eine Vielzahl von homogenen keramischen Nanopartikeln mit mindestens einer Art von Tellurverbindung;
- wobei die homogenen keramischen Nanopartikel eine mittlere Teilchengröße aufweisen, die aus einem Bereich von etwa 5 nm bis etwa 30 nm ausgewählt ist;
- wobei die keramischen Nanopartikel Teil eines Nanokomposits sind,
**dadurch gekennzeichnet, dass**
- die homogenen keramischen Nanopartikel jeweils mit einer Partikelbeschichtung (11) beschichtet sind;
- die Partikelbeschichtung mindestens eine Schicht (12) mit nanostrukturiertem, im Wesentlichen intaktem Kohlenstoffmaterial umfasst,
wobei das Verfahren umfasst:
- Bereitstellen eines Precursor-Pulvers einer Vielzahl von homogenen keramischen Nanopartikeln mit mindestens einer Art von Tellurverbindung, die eine mittlere Teilchengröße aufweisen, die aus einem Bereich von etwa 5 nm bis etwa 30 nm ausgewählt ist, wobei die homogenen keramischen Nanopartikel jeweils eine Precursor-Beschichtung mit nanostrukturiertem, im Wesentlichen intaktem Kohlenstoffmaterial umfassen, und
- Wärmebehandlung des Precursor-Pulvers, derart, dass das Nanokomposit durch Umwandlung der Precursor-Beschichtung in die Partikelbeschichtung (11) erzeugt wird.

10. Verfahren nach Anspruch 9, wobei das Bereitstellen des Precursor-Pulvers das Bereitstellen einer Pulvermischung aus einem Keramikpulver und einem Kohlenstoffpulver umfasst, wobei das Keramikpulver die Vielzahl von homogenen keramischen Nanopartikeln mit mindestens einer Art von Tellurverbindung umfasst, die eine mittlere Teilchengröße aufweisen, die aus einem Bereich von etwa 5 nm bis etwa 30 nm ausgewählt ist, wobei die keramischen Nanopartikel Teil eines Nanokomposits (1) sind,
**dadurch gekennzeichnet, dass**
das Kohlenstoffpulver das nanostrukturierte, im Wesentlichen intakte Kohlenstoffmaterial umfasst.

11. Verfahren nach Anspruch 10, wobei das Bereitstellen der Pulvermischung beinhaltet:
- Mahlen eines keramischen Rohmaterials des Keramikpulvers, woraus das Keramikpulver resultiert,
- Zugeben des Kohlenstoffpulvers zu dem Keramikpulver und
- Mischen des Keramikpulvers und des Kohlenstoffpulvers, sodass die Pulvermischung erzeugt wird.

12. Verfahren nach einem der vorhergehenden Ansprüche, wobei das Bereitstellen des Precursor-Pulvers ein mechanisches Verdichten des Precursor-Pulvers beinhaltet.

13. Verfahren nach einem der vorhergehenden Ansprüche, wobei die Wärmebehandlung bei bis zu 400 °C und insbesondere bei bis zu 350 °C durchgeführt wird.

14. Anwendung des thermoelektrischen Nanokomposits (1) nach Anspruch 1 bis Anspruch 8 als thermoelektrische Komponente für ein Wärme-Kraft-System.

## Revendications

1. Nanocomposite thermoélectrique (1), comprenant :
- une pluralité de nanoparticules céramiques homogènes (11) comprenant au moins un type de composé de tellurium ;
- les nanoparticules céramiques ont une taille moyenne de particules sélectionnée dans une plage d'environ 5 nm à environ 30 nm ;
- les nanoparticules céramiques font partie d'un nanocomposite,
**caractérisé en ce que**
- les nanoparticules céramiques sont dotées d'un revêtement particulaire (11) dans chaque cas ;
- le revêtement particulaire comprend au moins une couche (12) de matériau de carbone nanostructuré essentiellement intact.

2. Nanocomposite thermoélectrique (1) selon la revendication 1, dans lequel le matériau de carbone nanostructuré est sélectionné dans le groupe comprenant des fullerènes et des nanotubes de carbone.

3. Nanocomposite thermoélectrique (1) selon la revendication 2, dans lequel les fullerènes sont sélectionnés dans le groupe comprenant le C36, le C60 et le C80.

4. Nanocomposite thermoélectrique (1) selon l'une quelconque des revendications précédentes, dans lequel le matériau de carbone nanostructuré est modifié chimiquement.

5. Nanocomposite thermoélectrique (1) selon l'une quelconque des revendications précédentes, dans lequel la couche (12) est continue ou discontinue.

6. Nanocomposite thermoélectrique (1) selon l'une quelconque des revendications précédentes, dans lequel le revêtement particulaire (11) comprend cinq couches du matériau de carbone nanostructuré au maximum et, notamment, trois couches du matériau de carbone nanostructuré au maximum.

7. Nanocomposite thermoélectrique (1) selon l'une quelconque des revendications précédentes, dans lequel le composé de tellurium comprend au moins un élément sélectionné dans le groupe comprenant l'antimoine et le bismuth.

8. Nanocomposite thermoélectrique (1) selon l'une quelconque des revendications précédentes, dans lequel le composé de tellurium est au moins un tellure sélectionné dans le groupe comprenant Bi₂Te₃ et Sb₂Te₃.

9. Procédé de fabrication d'un nanocomposite thermoélectrique (1), le nanocomposite comprenant :
- une pluralité de nanoparticules céramiques homogènes comprenant au moins un type de composé de tellurium ;
- les nanoparticules céramiques homogènes ont une taille moyenne de particules sélectionnée dans une plage d'environ 5 nm à environ 30 nm ;
- les nanoparticules font partie d'un nanocomposite **caractérisé en ce que**
- les nanoparticules céramiques homogènes sont dotées d'un revêtement particulaire (11) dans chaque cas ;
- le revêtement particulaire comprend au moins une couche (12) de matériau de carbone nanostructuré essentiellement intact,
le procédé comprenant :
- fournir une poudre de précurseur constituée d'une pluralité de nanoparticules céramiques homogènes comprenant au moins un type de composé de tellurium ayant une taille moyenne de particules sélectionnée dans une plage d'environ 5 nm à environ 30 nm, dans lequel les nanoparticules céramiques homogènes sont dotées d'un revêtement de précurseur comprenant un matériau de carbone nanostructuré essentiellement intact dans chaque cas et
- traiter thermiquement la poudre de précurseur de telle sorte que le nanocomposite soit formé par conversion du revêtement de précurseur en revêtement particulaire (11).

10. Procédé selon la revendication 9, dans lequel la fourniture de la poudre de précurseur inclut la fourniture d'un mélange de poudres comprenant une poudre de céramique et une poudre de carbone, dans lequel la poudre de céramique comprend la pluralité de nanoparticules céramiques homogènes comprenant au moins un type de composé de tellurium ayant une taille moyenne de particules sélectionnée dans une plage d'environ 5 nm à environ 30 nm, les nanoparticules céramiques font partie d'un nanocomposite (1)
**caractérisé en ce que** la poudre de carbone comprend le matériau de carbone nanostructuré essentiellement intact.

11. Procédé selon la revendication 10, dans lequel la fourniture du mélange de poudres inclut
- le broyage d'un matériau brut céramique de la poudre de céramique, donnant la poudre de céramique,
- l'addition de la poudre de carbone à la poudre de céramique et
- le mélange de la poudre de céramique et de la poudre de carbone de manière à produire le mélange de poudres.

12. Procédé selon l'une quelconque des revendications précédentes, dans lequel la fourniture de la poudre de précurseur inclut un compactage mécanique de la poudre de précurseur.

13. Procédé selon l'une quelconque des revendications précédentes, dans lequel le traitement thermique est effectué à une température atteignant 400°C et, notamment, atteignant 350°C.

14. Application du nanocomposite thermoélectrique (1) selon les revendications 1 à 8 en tant que composant thermoélectrique pour un système de conversion de chaleur en énergie.
